# EUROPÄISCHE PATENTSCHRIFT

(11) **EP 1 883 284 B1**
(45) Veröffentlichungstag und Bekanntmachung des Hinweises auf die Patenterteilung: **29.06.2011**
(21) Anmeldenummer: 07012980.4
(22) Anmeldetag: 03.07.2007
(51) Int. Cl.: H05K 5/02, H05K 5/06, H05K 7/14

(54) **Gehäuse für eine Steuerung**
Casing for a controlling mechanism
Boîtier pour une commande

(30) Priorität: 28.07.2006 DE 102006034923
(43) Veröffentlichungstag der Anmeldung: 30.01.2008
(73) Patentinhaber: Jungheinrich Aktiengesellschaft, 22047 Hamburg (DE)
(72) Erfinder: Schuldt, Thomas, Dipl.-Ing., 22525 Hamburg (DE); Steiner, Michael, Dipl.-Ing., 22965 Todendorf (DE)
(74) Vertreter: Schildberg, Peter

(56) Entgegenhaltungen:
- EP-A- 0 792 094
- US-A- 5 552 961
- US-B1- 6 331 937

## Beschreibung

Die vorliegende Erfindung betrifft ein Gehäuse für eine Steuerung, das eine Aufnahme für einen Steckverbinder mit elektrischen Kontakten besitzt.

Das Gehäuse für eine Steuerung, die beispielsweise einen durch eine Person zu hedienenden Taster oder ein ähnliches Steuerelement besitzt, ist bei einem Arbeitseinsatz, beispielsweise im Bereich der Logistik, hohen Belastungen durch Stöße, Wasser- oder sonstige Umwelteinflüsse ausgesetzt. Gehäuse für Steuerungen wurden daher in der Vergangenheit stets, aus zwei miteinander verschraubten Schalen hergestellt, was zu entsprechend langen Herstellzeiten geführt hat.

Aus US 6,331,937 ist ein stiftförmiges Element bekannt, mit dem ein Kühlkörper federvorgespannt gegen eine Leiterplatte gedrückt werden kann.

Aus US 5,552,961 ist ein Gehäuse für eine Leiterplatte ohne Steckverbindung bekannt. Ein in dem Gehäuse angeordnete Leiterplatte wird über ein Adapterstück federvorgespannt entgegen wärmeleitende Polster gedrückt.

Aus EP 0 792 094 ist ein elektronisches Steuergerät mit einem Gehäuse bekannt. Das Gehäuse besteht aus einem Deckel und einem Bodenelement, wobei die Leiterplatte mit dem Bodenelement verklebt ist und der Deckel eine Durchbrechung für eine elektrische Steckverbindung besitzt. Bodenelement und Deckel sind durch eine schraublose Klipsverbindung miteinander verbunden, die durch einen umlaufenden Dichtring abgedichtet ist. Die Durchbrechung im Deckel für die elektrische Steckverbindung ist ebenfalls durch einen Dichtring abgedichtet.

Der Erfindung liegt die Aufgabe zugrunde, ein Gehäuse für eine Steuerung bereitzustellen, das stabil und robust ausgebildet ist und sich auch entsprechend schnell und leicht montieren läßt.

Die erfindungsgemäße Aufgabe wird durch ein Gehäuse mit den Merkmalen aus Anspruch 1 gelöst. Vorteilhafte Ausgestaltungen bilden den Gegenstand der Unteransprüche.

Das erfindungsgemäße Gehäuse ist für eine Steuerung vorgesehen und besitzt eine obere Schale, ein Bodenelement und eine Leiterplatte. Die Leiterplatte ist mit einer Aufnahme für einen Steckverbinder mit elektrischen Anschlüssen versehen. Die obere Schale besitzt eine Durchbrechung durch die die Aufnahme für den Steckverbinder von außen zugänglich ist. Erfindungsgemäß sind obere Schale und Bodenelement über Schnappverschlüsse dichtend miteinander verbunden. Erfindungsgemäß ist ein Federelement vorgesehen, das im geschlossenen Zustand des Gehäuses die Leiterplatte gegen das Bodenelement drückt. Bei der erfindungsgemäßen Ausgestaltung ist es nicht länger erforderlich, die Leiterplatte an einer der Schalen zu verschrauben oder die Schalen miteinander zu verschrauben. Über die Schnappverschlüsse werden obere Schale und Bodenelement aneinander gehalten und die Leiterplatte über mindestens ein Federelement gegen dass Bodenelement gedrückt. Hierdurch wird der Aufwand bei der Montage deutlich reduziert.

Bei dem erfindungsgemäßen Gehäuse ist das Bodenelement als Kühlkörper für Transistoren und andere Bauteile auf der Leiterplatte ausgebildet. Gleichzeitig bietet das Bodenelement somit auch einen ausreichenden Schutz und eine ausreichende Stabilität für das gesamte Gehäuse.

In einer bevorzugten Ausgestaltung ist mindestens ein Federelement in der oberen Schale gehalten. Hierdurch wird wiederum bei der Montage des Gehäuses sichergestellt, daß die Federelement richtig im Gehäuseinneren positioniert sind.

Hierdurch wird einerseits die Leiterplatte in dem Gehäuse gehalten und andererseits die Leiterplatte zur Wärmeableitung gegen das Bodenelement gedrückt.

In einer bevorzugten Ausgestaltung sind auf der Innenseite der oberen Schale Stifte vorgesehen, die senkrecht in den Innenraum vorstehen und auf die jeweils ein Federelement gesetzt ist. Das Federelement drückt die Leiterplatte gegen das Bodenelement.

Bevorzugt besitzen die Stifte Rastmittel, über die das Federelement auf den Stiften gehalten ist.

In einer zweckmäßigen Ausgestaltung ist die Aufnahme für den Steckverbinder über eine umlaufende Dichtung gegenüber der oberen Schale abgedichtet, wobei die obere Schale über das Dichtelement die Leiterplatte gegen das Bodenelement drückt. Das Dichtelement dient ebenso wie das Federelement dazu, die Leiterplatte gegen das Bodenelement zu drücken. Hierdurch wird ein fester Sitz der Leiterplatte in dem Gehäuse sichergestellt.

In einer bevorzugten Ausgestaltung besitzt die Leiterplatte mindestens eine Durchbrechung, wobei mindestens eine der Schalen mit einem zugehörigen Zentrierstift ausgestattet ist, um die Position der Leiterplatte relativ zu der Schale festzulegen.

Eine bevorzugte Ausgestaltung des erfindungsgemäßen Gehäuses wird nachfolgend anhand eines Beispiels näher erläutert.

Es zeigt:
- Fig. 1: eine perspektivische Ansicht des erfindungsgemäßen Gehäuses im geschlossenen Zustand,
- Fig. 2: eine perspektivische Ansicht zu der oberen Schale des Gehäuses,
- Fig. 3: eine Explosionsdarstellung in einer perspektivischen Ansicht und
- Fig. 4: eine auseinandergezogene Darstellung in einer Schnittansicht.

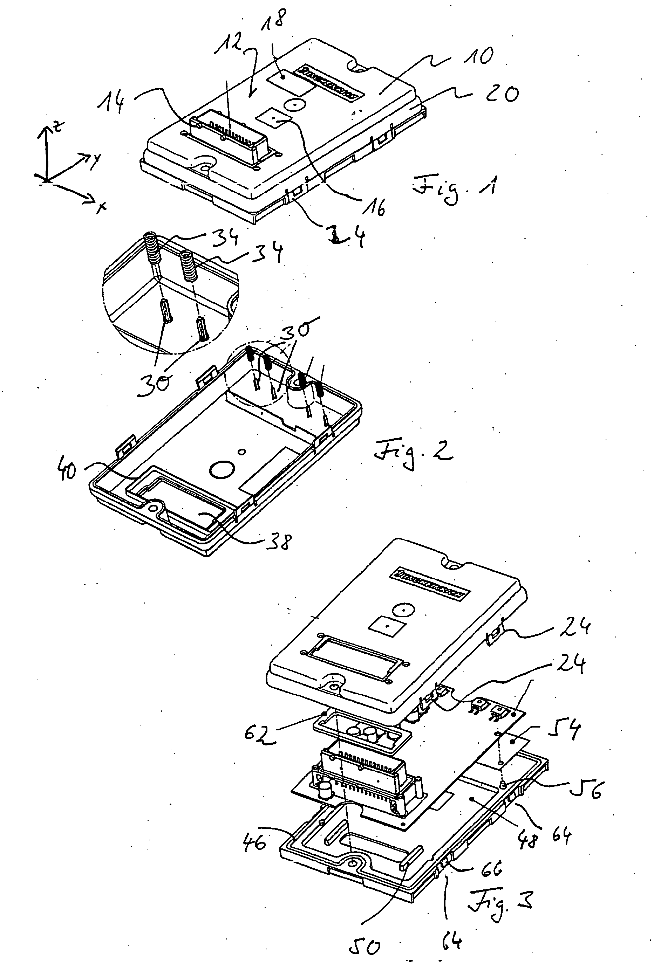

Fig. 1 zeigt in einer perspektivischen Ansicht das erfindungsgemäße Gehäuse 10. Das Gehäuse 10 besitzt eine im wesentlichen rechteckige Form, wobei das Gehäuse in seiner Grundform einen Quader bildet. Bezogen auf das eingezeichnete Dreibein in Fig. 1 besitzt das Gehäuse 10 seine größte Länge in Y-Richtung und eine Breite in X-Richtung, die etwas mehr als die Hälfte der Länge beträgt. Die Höhe in Z-Richtung des Gehäuses beträgt ungefähr ein viertel der Breite. Die in Fig. 1 nach oben weisende Fläche 12 des Gehäuses 10 besitzt ungefähr mittig ein rechteckiges Membranfeld 16. Ebenfalls steht aus der Fläche 12 eine rechteckige Begrenzungswand 14 für eine Steckverbindung vor. Zusätzlich ist auf der Oberseite 12 des Gehäuses 10 ein Feld 18 vorgesehen, das beispielsweise zur Befestigung eines Typenschilds dient.

Die obere Schale des Gehäuses besitzt einen umlaufenden Wulst 20, der an seinem unteren Ende in eine Dichtlippe 22 mündet. Der Übergang zwischen der Seitenwand der oberen Schale und der Wulst 20 ist leicht abgerundet. Auf jeder Längsseite (Y-Richtung) der oberen Gehäuseschale sind zwei U-förmige Schnappverschlüsse 24 vorgesehen. Die Schnappverschlüsse 24 besitzen jeweils eine rechteckige Durchbrechung 26 und eine über die gesamte Breite des Verschlusses sich erstreckende Schnappkante 28.

Wie in Fig. 2 dargestellt besitzt die obere Schale des Gehäuses 10 auf Ihrer Innenseite vier parallel zu einer Schmalkante (X-Achse) angeordnete Raststifte 30, die an ihrem unteren, zur Innenseite der oberen Schale weisenden Ende Rastnasen 32 besitzen. Auf die Stifte 30 ist jeweils eine Spiralfeder 34 gesteckt, die auf dem Stift verrastet und so für eine spätere Montage gehalten wird.

Parallel zu den Stiften 30 ist auf der Innenseite der oberen Schale eine Trennwand 36 vorgesehen. Die Trennwand 36 dient als zusätzliche Abstützung für die obere Gehäuseschale.

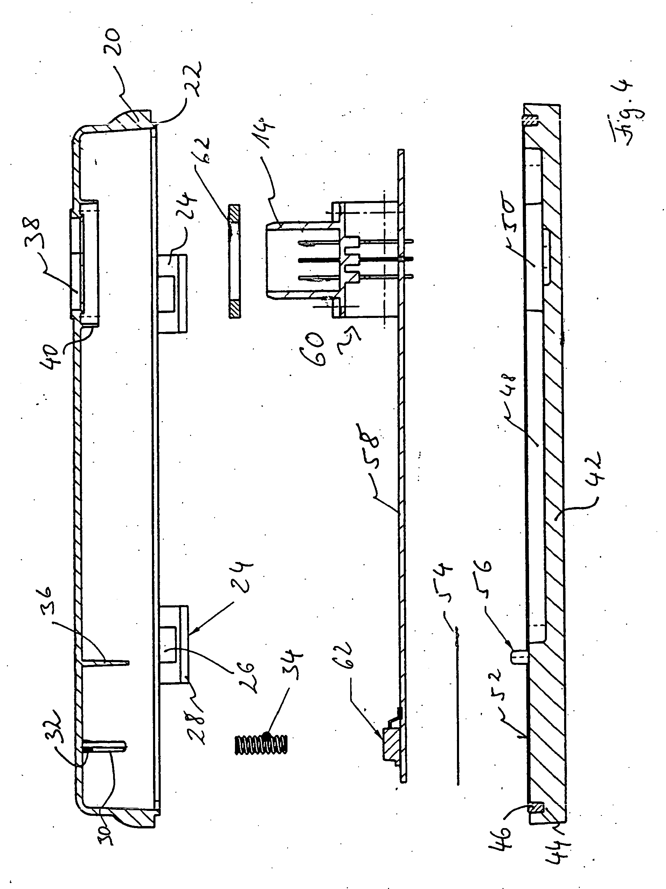

In Fig. 2 ist ebenfalls gut die Durchbrechung 38 zu erkennen, über die die Seitenwand 14 des elektrischen Anschlusses vorsteht. Wie deutlich in Fign. 2 und 4 zu erkennen, besitzt die Durchbrechung 38 eine umlaufende Dichtkante 40.

Das Gegenstück zu der oberen Gehäuseschale bildet das Bodenelement 42, das als massiver Metallkörper ausgebildet ist. Umlaufend besitzt das Bodenelement 42 eine Nut 44, in der ein Dichtelement 46 angeordnet ist. Der Grund von dem Bodenelement 42 besitzt eine großflächige Vertiefung 48, in der im Bereich der Steckverbindungen zwei parallel zueinander sich in Y-Richtung erstreckende Abstützvorsprünge 50 vorgesehen sind. Die Abstützvorsprünge 50 schließen bündig mit dem Grund 52 des Bodenelements 42 in dem nicht vertieften Abschnitt ab. Aus dem Grund 52 des Bodenelements 42 stehen Zentrierstifte 56 vor. In dem Bereich, in dem das Bodenelement keine Vertiefung 48 besitzt, ist eine Isolierfolie 54 vorgesehen, die die Leiterplatte 58 von dem Bodenelement 42 trennt. Die Leiterplatte 58 ist in dem dargestellten Ausführungsbeispiel zur besseren Übersicht nicht vollständig bestückt. Lediglich die Aufnahme für den elektrischen Steckverbinder 60 sowie Transistoren 62 sind auf der Leiterplatte 18 dargestellt. Die Feder 34 drückt auf die Transistoren 62, so daß die Leiterplatte 58 im Bereich der Transistoren 62 gegen die Isolierfolie 54 auf das Bodenelement 42 gedrückt wird. Durch den engen Kontakt erfolgt eine besonders gute Wärmeableitung von den Transistoren 62 hin zu dem Bodenelement 42, das aus Metall hergestellt ist. Die Aufnahme 60 für den elektrischen Steckverbinder besitzt eine Reihe von elektrischen Kontakten 62, von denen in den Zeichnungen beispielhaft drei dargestellt sind. Die Aufnahme besitzt die bereits oben angesprochene umlaufende Wand 14. Der Grund der Aufnahme 60 ist gegenüber der Leiterplatte 58 erhöht. Um die Umgrenzungswand 14 ist eine Dichtung 62 angeordnet, die die Durchbrechung 38 mit der Dichtkante 40 in der oberen Schale des Gehäuses gegenüber dem Anschluß 60 abdichtet.

Wie in Fig. 3 dargestellt besitzt das Bodenelement seitlich Vertiefungen 64 mit einer zentralen Schnappnase 66, die mit der Schnappkante 28 des Schnappverschlusses 24 zusammenwirkt. Hierbei hintergreift die Schnappnase 66 über die Durchbrechung 26 den unteren Steg des Schnappverschlusses 24.

Zur Montage des Gehäuses werden in einem ersten Schritt die vier Federn 34 auf die Stifte 30 aufgesetzt, bis diese verrastet sind. Anschließend wird die Isolierfolie 54 auf dem Grund 52 gelegt und über den Zentrierstift 56 ausgerichtet. Nachfolgend wird die Leiterplatte 58 auf das Bodenelement 52 gelegt und ebenfalls anhand der Zentrierstifte 56 ausgerichtet. In einem weiteren Schritt wird das Oberteil des Gehäuses bei aufgesetztem Dichtring 62 aufgesetzt, so daß der Anschluß für die Steckverbindung aus dem Gehäuse herausragt. Anschließend wird durch ein kräftiges Zusammendrücken des Gehäuses dieses über die Schnappverschlüsse verschlossen.

Bei dem erfindungsgemäßen Gehäuse ist dann die Leiterplatte 28 sicher in dem Gehäuse gehalten.

Das Gehäuse wird an dem Fahrzeugrahmen so befestigt, daß kein Wasser auf dem Deckel stehen bleibt, sondern direkt abfließt. Das rechteckige Membranfeld 16 ist mit einem Stoffgewebe, bevorzugt einem wasserundurchlässigen Gewebe abgedeckt. Das Gewebe ist ausgebildet, um für Wasserdampf und Luft durchlässig zu sein. Ein solches permeables Gewebe stellt sicher, daß bei einem Druckausgleich aufgrund einer Temperaturänderung kein Wasser in flüssiger Form, sondern nur dampfförmig in die Steuerung gelangt. Dadurch muß die Steuerung nicht druckfest abgedichtet sein und es wird trotzdem der Eintritt von Wasser in die Steuerung vermieden.

## Patentansprüche

1. Gehäuse für eine Steuerung mit einer oberen Schale (12), einem Bodenelement (42) und einer Leiterplatte (58), auf der eine Aufnahme für eine Steckverbindung (60) mit elektrischen Anschlüssen vorgesehen ist, die über eine Durchbrechung (38) in der oberen Schale von außen zugänglich ist, wobei die obere Schale und das Bodenelement mit Schnappverschlüssen (24) dichtend miteinander verbunden sind, **dadurch gekennzeichnet, dass** die Leiterplatte über mindestens ein Federelement (34) im geschlossenen Zustand des Gehäuses gegen das Bodenelement gedrückt ist und das Bodenelement als Kühlkörper für Transistoren und andere Bauteile auf der Leiterplatte ausgebildet ist.

2. Gehäuse nach Anspruch 1, **dadurch gekennzeichnet, daß** das Bodenelement (42) aus Metall hergestellt ist.

3. Gehäuse nach Anspruch 2, **dadurch gekennzeichnet, daß** die Leiterplatte (58) in mindestens einem Abschnitt flächig an dem Bodenelement anliegt.

4. Gehäuse nach einem der Ansprüche 1 bis 3, **dadurch gekennzeichnet, daß** das Federelement in der oberen Schale gehalten ist.

5. Gehäuse nach einem der Ansprüche 1 bis 4, **dadurch gekennzeichnet, daß** auf der Innenseite der oberen Schale mindestens ein Stift (30) vorgesehen ist, der senkrecht in den Innenraum vorsteht und auf den jeweils das Federelement (34) gesetzt ist.

6. Gehäuse nach Anspruch 5, **dadurch gekennzeichnet, daß** der mindestens eine Stift (30) Rastmittel (32) für das Federelement (34) besitzt.

7. Gehäuse nach einem der Ansprüche 1 bis 5, **dadurch gekennzeichnet, daß** die Aufnahme (60) für den elektrischen Steckverbinder über ein umlaufendes Dichtelement (62) gegenüber der oberen Schale abgedichtet ist, wobei die obere Schale über das Dichtelement die Leiterplatte (58) ebenso gegen das Bodenelement (42) drückt.

8. Gehäuse nach einem der Ansprüche 1 bis 7, **dadurch gekennzeichnet, daß** die Leiterplatte (58) mindestens eine Durchbrechung (38) besitzt und das Bodenelement mindestens einen entsprechend positionierten Zentrierstift.

## Claims

1. Casing for a controlling mechanism, with an upper shell (12), a bottom element (42) and a printed board (58) on which an accommodation for a plug-in connection (60) with electric contacts is provided, which can be accessed from the outside via an opening (38) in the upper shell, wherein the upper shell and the bottom element are sealingly connected to each other via snaps (24), **characterised in that** the printed board is pushed against the bottom element by a least one spring element (34) in the closed condition of the casing, and the bottom element is realised as a heat sink for transistors and other components on the printed board.

2. A casing according to claim 1, **characterised in that** the bottom element (42) is made of metal.

3. A casing according to claim 2, **characterised in that** the printed board (58) rests sheet-like on the bottom element in at least a portion.

4. A casing according to any one of claims 1 to 3, **characterised in that** the spring element is held in the upper shell.

5. A casing according to any one of claims 1 to 4, **characterised in that** at least one pin (30) is provided on the inner side of the upper shell, which perpendicularly projects into the interior space, and onto which the respective spring element (34) is set.

6. A casing according to claim 5, **characterised in that** the at least one pin (30) has catching means (32) for the spring element (34).

7. A casing according to any one of claims 1 to 5, **characterised in that** the accommodation (60) for the electric plug-in connector is sealed with respect to the upper shell via a circumferential sealing element (62), wherein the upper shell also pushes the printed board (58) against the bottom element (42) via the sealing element.

8. A casing according to any one of claims 1 to 7, **characterised in that** the printed board (58) has at least one opening (38), and the bottom element at least one correspondingly positioned centering pin.

## Revendications

1. Boîtier pour une commande, avec une coque supérieure (12), un élément de fond (42) et une plaquette imprimée (58) sur laquelle est pourvu un logement pour une fiche de raccordement (60) avec des contacts électriques et qui est accessible de l'extérieur via une ouverture (38) dans la coque supérieure, la coque supérieure et l'élément de fond étant connectés l'un à l'autre de façon étanche par des assemblages à encliquetage (24), **caractérisé en ce que** la plaquette imprimée est poussée contre l'élément de fond par au moins un élément de ressort (34) dans la condition fermée du boîtier, et que l'élément de fond est formé comme un élément réfrigérant pour des transistors et autres composants sur la plaquette imprimée.

2. Boîtier selon la revendication 1, **caractérisé en ce que** l'élément de fond (42) est fait de métal.

3. Boîtier selon la revendication 2, **caractérisé en ce que** la plaquette imprimée (58) reste en nappe sur l'élément de fond dans au moins une partie.

4. Boîtier selon l'une quelconque des revendications 1 à 3, **caractérisé en ce que** l'élément de ressort est tenu dans la coque supérieure.

5. Boîtier selon l'une quelconque des revendications 1 à 4, **caractérisé en ce que** au moins une broche (30) est pourvue dans le côté intérieur de la coque supérieure, qui projette de façon perpendiculaire dans intérieur et sur laquelle l'élément de ressort (34) correspondant est posé.

6. Boîtier selon la revendication 5, **caractérisé en ce que** l'au moins une broche (30) a des moyens d'encliquetage (32) pour l'élément de ressort (34).

7. Boîtier selon l'une quelconque des revendications 1 à 5, **caractérisé en ce que** le logement (60) pour la fiche de raccordement électrique est fait étanche par rapport a la coque supérieure via un élément d'étanchéité circonférentiel (62), la coque supérieure poussant aussi la plaquette imprimée (58) contre l'élément de fond (42) via l'élément d'étanchéité.

8. Boîtier selon l'une quelconque des revendications 1 à 7, **caractérisé en ce que** la plaquette imprimée (58) a au moins une ouverture (38), et l'élément de fond au moins une pointe de centrage positionnée de façon correspondante.
